# EUROPÄISCHE PATENTANMELDUNG

(11) **EP 4 358 658 A1**
(43) Veröffentlichungstag der Anmeldung: **24.04.2024**
(21) Anmeldenummer: 22202635.3
(22) Anmeldetag: 20.10.2022
(51) Int. Cl.: H05K 5/00

(54) **VERFAHREN ZUR HERSTELLUNG EINER ANORDNUNG MIT EINEM GEHÄUSETEIL ZUR AUFNAHME EINES HALBLEITERELEMENTS UND EINER BODENPLATTE**

(71) Anmelder: Siemens Aktiengesellschaft, 80333 München (DE)
(72) Erfinder: Hüttner, Rainer, 96050 Bamberg (DE); Werner, Ronny, 90429 Nürnberg (DE)
(74) Vertreter: Siemens Patent Attorneys

(57) **Zusammenfassung**

Die Erfindung betrifft ein Verfahren zur Herstellung einer Anordnung (2) mit einem Gehäuseteil (4) zur Aufnahme eines Halbleiterelements (10) und einer Bodenplatte (6). Um ein möglichst einfaches und kostengünstiges Herstellungsverfahren anzugeben, welche eine zuverlässige Verdrahtung ermöglicht, werden folgende Schritte vorgeschlagen: Ausbilden (42) einer ersten Gehäusekomponente (12), wobei zumindest ein Pin (16) zumindest teilweise in einen ersten Kunststoffrahmen (18) eingegossen wird, wobei an dem Pin (16) eine Verdrahtungsfläche (20) ausgebildet ist, Einlegen (44) einer zweiten Gehäusekomponente (14), welche einen schwingungsdämpfenden Werkstoff (22) aufweist, in die erste Gehäusekomponente (12) zur Ausbildung des Gehäuseteils (4), wobei der schwingungsdämpfende Werkstoff (22) auf einer Kontaktfläche (24), welche auf einer der Verdrahtungsfläche (20) abgewandten Seite der ersten Gehäusekomponente (12) angeordnet ist, lose kontaktiert wird, Verbinden (46) des Gehäuseteils (4) mit der Bodenplatte (6), wobei die zweite Gehäusekomponente (14), insbesondere unmittelbar, mit der Bodenplatte (6) kontaktiert wird.

## Beschreibung

Die Erfindung betrifft ein Verfahren zur Herstellung einer Anordnung mit einem Gehäuseteil zur Aufnahme eines Halbleiterelements und einer Bodenplatte

Ferner betrifft die Erfindung eine Anordnung mit einem Gehäuseteil zur Aufnahme eines Halbleiterelements und einer Bodenplatte.

Überdies betrifft die Erfindung ein Halbleitermodul mit mindestens einer derartigen Anordnung.

Weiterhin betrifft die Erfindung einen Stromrichter mit mindestens einem derartigen Halbleitermodul.

Darüber hinaus betrifft die Erfindung ein Computerprogrammprodukt, umfassend Befehle, die bei einer Ausführung des Programms durch einen Computer diesen veranlassen, ein, insbesondere mechanisches und/oder elektrisches, Verhalten einer derartigen Anordnung simulieren.

Eine derartige Anordnung kann Teil eines Halbleitermoduls sein, das in der Regel in einem Stromrichter zum Einsatz kommt. Unter einem Stromrichter ist beispielsweise ein Gleichrichter, ein Wechselrichter, ein Umrichter oder ein Gleichspannungswandler zu verstehen. Die Anordnung kann Teil eines Gehäuses für zumindest ein Halbleiterbauelement sein. Derartige Gehäuse umfassen in der Regel mehrere Gehäuseteile, beispielsweise einen oder mehrere Gehäuse-Rahmenteile, eine Gehäuse-Grundplatte, welche auch Bodenplatte genannt wird, und einen Gehäuse-Deckel. Die einzelnen Gehäuse-Teile werden üblicherweise miteinander verklebt, sodass zumindest ein Halbleiterelement, beispielsweise ein integrierter Schaltkreis, im Inneren des Gehäuses vollständig von dem Gehäuse umschlossen ist. In einem derartigen Halbleitermodul zum Einsatz kommende Halbleiterelemente können unter anderem Transistoren, Dioden, Triacs oder Thyristoren sein. Die Transistoren sind beispielsweise als Insulated-Gate-BipolarTransistoren (IGBTs), Feldeffekttransistoren oder Bipolartransistoren ausgeführt. Zur elektrischen Kontaktierung sind üblicherweise aus dem Gehäuse-Inneren nach außen geführte elektrische Kontakte, sogenannte Pins, vorgesehen.

Die Offenlegungsschrift WO 2021/209186 A1 beschreibt ein Halbleitermodul mit einem Gehäuse, mindestens einem Halbleiterbauelement, einem ersten Substrat und einem zweiten Substrat. Um ein Halbleitermodul anzugeben, welches, im Vergleich zum Stand der Technik, kompakter ist, wird vorgeschlagen, dass zumindest das Halbleiterbauelement und das erste Substrat in dem Gehäuse angeordnet sind, wobei das Halbleiterbauelement elektrisch leitend mit mindestens einem Pin verbunden ist, wobei der mindestens eine Pin mit dem zweiten Substrat kontaktiert und innerhalb des Gehäuses unlösbar verbunden ist, wobei das erste Substrat über den mindestens einen Pin kraftschlüssig im Gehäuse verbunden ist.

Innerhalb eines derartigen Gehäuses können elektrische Verbindungen unter anderem durch Drahtbonden hergestellt werden. Ein gängiges Verfahren ist dabei das Ultraschall-Drahtbonden, bei welchem ein Bonddraht mit einer Bondfläche durch Druck und Ultraschallschwingungen miteinander verschweißt werden. Durch den Bondprozess auftretende Schwingungen beim Ultraschall-Drahtbonden von Bondflächen der Pins können unerwünschten Schwingungen, beispielsweise durch Resonanzen, angeregt werden, so dass eine Schweißverbindung zwischen dem Bonddraht und der Bondfläche eines Pins nicht oder nicht mit der geforderten Qualität zustande kommt.

Eine Aufgabe der vorliegenden Erfindung ist es daher, ein möglichst einfaches und kostengünstiges Verfahren zur Herstellung einer Anordnung mit einem Gehäuseteil zur Aufnahme eines Halbleiterelements und einer Bodenplatte bereitzustellen, welche eine zuverlässige Verdrahtung ermöglicht.

Diese Aufgabe wird erfindungsgemäß gelöst durch ein Verfahren zur Herstellung einer Anordnung mit einem Gehäuseteil zur Aufnahme eines Halbleiterelements und einer Bodenplatte umfassend folgende Schritte: Ausbilden einer ersten Gehäusekomponente, wobei zumindest ein Pin zumindest teilweise in einen ersten Kunststoffrahmen eingegossen wird, wobei an dem Pin eine Verdrahtungsfläche ausgebildet wird, Einlegen einer zweiten Gehäusekomponente, welche einen schwingungsdämpfenden Werkstoff aufweist, in die erste Gehäusekomponente zur Ausbildung des Gehäuseteils, wobei der schwingungsdämpfende Werkstoff auf einer Kontaktfläche, welche auf einer der Verdrahtungsfläche abgewandten Seite der ersten Gehäusekomponente angeordnet ist, lose kontaktiert wird, Verbinden des Gehäuseteils mit der Bodenplatte, wobei die zweite Gehäusekomponente, insbesondere unmittelbar, mit der Bodenplatte kontaktiert wird.

Ferner wird die Aufgabe erfindungsgemäß gelöst durch eine Anordnung mit einem Gehäuseteil zur Aufnahme eines Halbleiterelements und einer Bodenplatte, wobei der Gehäuseteil eine erste Gehäusekomponente und eine zweite Gehäusekomponente umfasst, wobei die erste Gehäusekomponente wenigstens einen Pin aufweist, wobei der Pin zumindest teilweise in einen ersten Kunststoffrahmen eingegossen ist, wobei an dem Pin eine Verdrahtungsfläche ausgebildet ist, wobei die zweite Gehäusekomponente in der ersten Gehäusekomponente zur Ausbildung des Gehäuseteils eingelegt ist, wobei die zweite Gehäusekomponente einen schwingungsdämpfenden Werkstoff aufweist, wobei der schwingungsdämpfende Werkstoff auf einer Kontaktfläche, welcher auf einer der Verdrahtungsfläche abgewandten Seite der ersten Gehäusekomponente angeordnet ist, lose kontaktiert ist, wobei der Gehäuseteil derartig mit der Bodenplatte verbunden ist, dass die zweite Gehäusekomponente mit der Bodenplatte in, insbesondere unmittelbarem, Kontakt steht.

Überdies wird die Aufgabe erfindungsgemäß gelöst durch ein Halbleitermodul mit mindestens einer derartigen Anordnung.

Weiterhin wird die Aufgabe erfindungsgemäß gelöst durch einen Stromrichter mit mindestens einem derartigen Halbleitermodul.

Darüber hinaus wird die Aufgabe erfindungsgemäß durch ein Computerprogrammprodukt, umfassend Befehle, die bei einer Ausführung des Programms durch einen Computer diesen veranlassen, ein, insbesondere mechanisches und/oder elektrisches, Verhalten einer derartigen Anordnung zu simulieren, gelöst.

Die in Bezug auf das Verfahren nachstehend angeführten Vorteile und bevorzugten Ausgestaltungen lassen sich sinngemäß auf die Anordnung, das Halbleitermodul, den Stromrichter und das Computerprogrammprodukt übertragen.

Der Erfindung liegt die Überlegung zugrunde, eine zuverlässige Verdrahtung einer Verdrahtungsfläche zumindest eines Pins, welcher zumindest teilweise in einen ersten Kunststoffrahmen einer ersten Gehäusekomponente eingegossen ist, durch Dämpfung von während des Verdrahtungsprozesses auftretende Schwingungen mittels eines schwingungsdämpfenden Werkstoffs zu ermöglichen. Hierbei wird ein zumindest zweiteiliger Gehäuseteil aus einer ersten Gehäusekomponente und einer zweiten Gehäusekomponente hergestellt, wobei die erste Gehäusekomponente einen ersten Kunststoffrahmen umfasst, in welchen zumindest ein Pin mit einer Verdrahtungsfläche eingegossen wird. Beispielsweise ist der erste Kunststoffrahmen ringförmig, insbesondere rechteckringförmig, ausgeführt und konfiguriert ein Halbleiterelement vollständig zu umgeben. In einem weiteren, insbesondere darauffolgenden, Schritt wird eine zweite Gehäusekomponente, welche einen schwingungsdämpfenden Werkstoff aufweist, in die erste Gehäusekomponente zur Ausbildung des Gehäuseteils eingelegt. Der schwingungsdämpfende Werkstoff kann beispielsweise Silikon enthalten. Das Einlegen kann eine Verbindung der Gehäusekomponenten, beispielsweise durch Einpressen, einschließen. Der schwingungsdämpfende Werkstoff der zweiten Gehäusekomponente wird auf einer Kontaktfläche der ersten Gehäusekomponente, welche auf einer der Verdrahtungsfläche abgewandten Seite angeordnet ist, lose kontaktiert. Unter einer losen Kontaktierung ist in diesem Zusammenhang zu verstehen, dass der schwingungsdämpfende Werkstoff lösbar, das heißt z.B. ohne eine stoffschlüssige Verbindung, wie z.B. eine adhäsive Verbindung, mit der Kontaktfläche kontaktiert wird. Die lose Kontaktierung kann ein Anpressen des schwingungsdämpfenden Werkstoffs einschließen. Beispielsweise wird der Silikon enthaltende schwingungsdämpfenden Werkstoff im ausgehärteten Zustand mit der Kontaktfläche kontaktiert. In einem weiteren, insbesondere darauffolgenden, Schritt wird der Gehäuseteil mit der Bodenplatte verbunden, wobei die zweite Gehäusekomponente, insbesondere unmittelbar, mit der Bodenplatte kontaktiert wird. Durch die lose Kontaktierung des schwingungsdämpfenden Werkstoffs mit der auf der Verdrahtungsfläche abgewandten Seite angeordneten Kontaktfläche wird eine verbesserte Dämpfung von während des Verdrahtungsprozesses auftretenden Schwingungen erreicht. Ferner wird der Herstellungsprozess durch die lose Kontaktierung des schwingungsdämpfenden Werkstoffs vereinfacht, da die Zahl der Prozessschritte reduziert wird. Beispielsweise entfallen ein aufwändiger Dispensprozess sowie ein nachgelagerter Trocknungsprozess. Somit wird der Herstellungsprozess durch das beschriebene Verfahren vereinfacht und es werden Kosten durch die Reduzierung der Prozessschritte eingespart.

Ein Computerprogrammprodukt, welches Befehle umfasst, die bei einer Ausführung des Programms durch einen Computer diesen veranlassen, ein, insbesondere mechanisches und/oder elektrisches, Verhalten der beschriebenen Anordnung zu simulieren kann einen "digitalen Zwilling", auch "digital twin" genannt, umfassen oder als ein solcher ausgebildet sein. Ein derartiger digitaler Zwilling ist beispielsweise in der Offenlegungsschrift US 2017/0286572 A1 dargestellt. Der Offenbarungsgehalt von US 2017/0286572 A1 wird durch Verweisung in die vorliegende Anmeldung mit einbezogen. Der "digitale Zwilling" ist beispielsweise eine digitale Repräsentanz der für die Herstellung und/oder den Betrieb der Anordnung relevanten Komponenten.

Eine weitere Ausführungsform sieht vor, dass der schwingungsdämpfende Werkstoff auf der Kontaktfläche flächig, insbesondere vollflächig, kontaktiert wird. Durch die flächige, insbesondere vollflächige, Kontaktierung des schwingungsdämpfenden Werkstoffs werden während des Verdrahtungsprozesses auftretende Schwingungen optimal gedämpft.

Eine weitere Ausführungsform sieht vor, dass auf der Bodenplatte zumindest ein Halbleiterelement angeordnet wird, wobei nach dem Verbinden des Gehäuseteils mit der Bodenplatte ein Verdrahten der Verdrahtungsfläche des Pins mit dem Halbleiterelement erfolgt, wobei beim Verdrahten der Verdrahtungsfläche auftretende Schwingungen zumindest teilweise durch den schwingungsdämpfenden Werkstoff gedämpft werden. Verdrahtungselemente können unter anderem Bonddrähte oder Bondbänder sein, welche, insbesondere durch Ultraschall-Drahtbonden, verschweißt werden. Schwingungen derartiger Bondverbindungen werden durch den schwingungsdämpfenden Werkstoff optimal gedämpft.

Eine weitere Ausführungsform sieht vor, dass das zumindest eine Halbleiterelement vor dem Verbinden des Gehäuseteils mit der Bodenplatte über ein Substrat elektrisch isolierend und thermisch leitend mit der Bodenplatte verbunden wird. Das Substrat kann unter anderem als DCB (Direct Copper Bonded) Substrat ausgeführt sein. Beispielsweise ist das Halbleiterelement als vertikaler Transistor, insbesondere als IGBT oder vertikaler SiC-MOSFET, ausgeführt, wobei eine derartige Verbindung über ein Substrat platzsparend und kostengünstig ist. Beispielsweise wird die Verdrahtungsfläche des zumindest einen Pins mit dem Substrat verdrahtet, wobei das Substrat über ein weiteres Verdrahtungselement mit dem Halbleiterelement verbunden wird. Alternativ kann die Verdrahtungsfläche des zumindest einen Pins direkt mit dem Halbleiterelement verdrahtet werden. Durch die Reihenfolge der Prozessschritte wird ein Herstellungsprozess mit einer geringen Zahl von Prozessschritten erreicht.

Eine weitere Ausführungsform sieht vor, dass das Verbinden des Gehäuseteils durch eine stoffschlüssige, insbesondere adhäsive, Verbindung der ersten Gehäusekomponente und/oder der der zweiten Gehäusekomponente mit der Bodenplatte erfolgt. Beispielsweise wird der erste Kunststoffrahmen oder der zweite Kunststoffrahmen des Gehäuseteils adhäsiv mit der Bodenplatte verbunden. Insbesondere wird eine adhäsive Verbindung des Gehäuseteils mit der Bodenplatte unter Spannung ausgehärtet. Durch eine derartige stoffschlüssige Verbindung wird die dämpfende Wirkung des schwingungsdämpfenden Werkstoffs minimal beeinflusst.

Eine weitere Ausführungsform sieht vor, dass die zweiten Gehäusekomponente einen zweiten Kunststoffrahmen umfasst, auf welchem vor dem Einlegen, insbesondere umlaufend, der schwingungsdämpfende Werkstoff aufgebracht wird. Beispielsweise ist der zweiten Kunststoffrahmen ringförmig, insbesondere rechteckringförmig, ausgeführt und konfiguriert ein Halbleiterelement vollständig zu umgeben. Insbesondere ein umlaufendes Aufbringen des schwingungsdämpfenden Werkstoffs sorgt für eine bestmögliche Schwingungsdämpfung. Durch den zweiten Kunststoffrahmen wird eine stabile Konstruktion und eine einfache Verbindung bei ausreichender Schwingungsdämpfung ermöglicht.

Eine weitere Ausführungsform sieht vor, dass beim Einlegen der zweiten Gehäusekomponente eine kraftschlüssige Verbindung zwischen den Gehäusekomponenten hergestellt wird. Insbesondere wird eine kraftschlüssige Verbindung zwischen dem ersten Kunststoffrahmen der ersten Gehäusekomponente und dem zweiten Kunststoffrahmen der zweiten Gehäusekomponente hergestellt. Eine derartige kraftschlüssige Verbindung ist beispielsweise durch Verklemmen einfach und kostengünstig herstellbar. Unter anderem kann eine derartige kraftschlüssige Verbindung einen nachgelagerten Klebeprozess erleichtern.

Eine weitere Ausführungsform sieht vor, dass der schwingungsdämpfende Werkstoff als, insbesondere umlaufende, Silikonschicht ausgeführt ist, welche durch ein Siebdruckverfahren oder durch Dispensen auf den zweiten Kunststoffrahmen aufgebracht und anschließend ausgehärtet wird, wobei die ausgehärtete Silikonschicht beim Einlegen der zweiten Gehäusekomponente, insbesondere flächig, mit der Kontaktfläche kontaktiert wird. Durch ein derartiges Vorapplizieren ist die ausgehärtete Silikonschicht lose bzw. lösbar mit der Kontaktfläche kontaktierbar, wodurch eine verbesserte Dämpfung von während des Verdrahtungsprozesses auftretenden Schwingungen erreicht wird. Ferner wird der Herstellungsprozess durch die lose Kontaktierung des schwingungsdämpfenden Werkstoffs vereinfacht.

Eine weitere Ausführungsform sieht vor, dass die zweite Gehäusekomponente als schwingungsdämpfender Rahmen, welcher aus dem schwingungsdämpfenden Werkstoff hergestellt ist, ausgeführt ist. Beispielsweise ist der schwingungsdämpfende Rahmen als ringförmiger, insbesondere rechteckringförmiger Silikonrahmen oder Gummirahmen ausgeführt. Durch Verwendung eines derartigen schwingungsdämpfenden Rahmens wird der Herstellungsprozess vereinfacht.

Eine weitere Ausführungsform sieht vor, dass beim Einlegen der zweiten Gehäusekomponente eine kraftschlüssige Verbindung zwischen der ersten Gehäusekomponente und dem schwingungsdämpfenden Rahmen hergestellt wird. Eine derartige kraftschlüssige Verbindung ist beispielsweise durch Verklemmen einfach und kostengünstig herstellbar. Darüber hinaus erleichtert die kraftschlüssige Verbindung den weiteren Herstellungsprozess.

Im Folgenden wird die Erfindung anhand der in den Figuren dargestellten Ausführungsbeispiele näher beschrieben und erläutert.

Es zeigen:
- FIG 1: eine schematische Schnittdarstellung einer ersten Ausführungsform einer Anordnung mit einem Gehäuseteil und einer Bodenplatte,
- FIG 2: eine vergrößerte schematische Schnittdarstellung der ersten Ausführungsform der Anordnung,
- FIG 3: eine vergrößerte schematische Schnittdarstellung einer zweiten Ausführungsform einer Anordnung mit einem Gehäuseteil und einer Bodenplatte,
- FIG 4: eine schematische Darstellung eines Gehäuseteils in einer Draufsicht,
- FIG 5: eine dreidimensionale Darstellung einer dritten Ausführungsform einer Anordnung mit einem Gehäuseteil und einer Bodenplatte,
- FIG 6: ein Ablaufdiagramm eines Verfahrens zur Herstellung eines Halbleitermoduls,
- FIG 7: eine schematische Darstellung eines Stromrichters.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

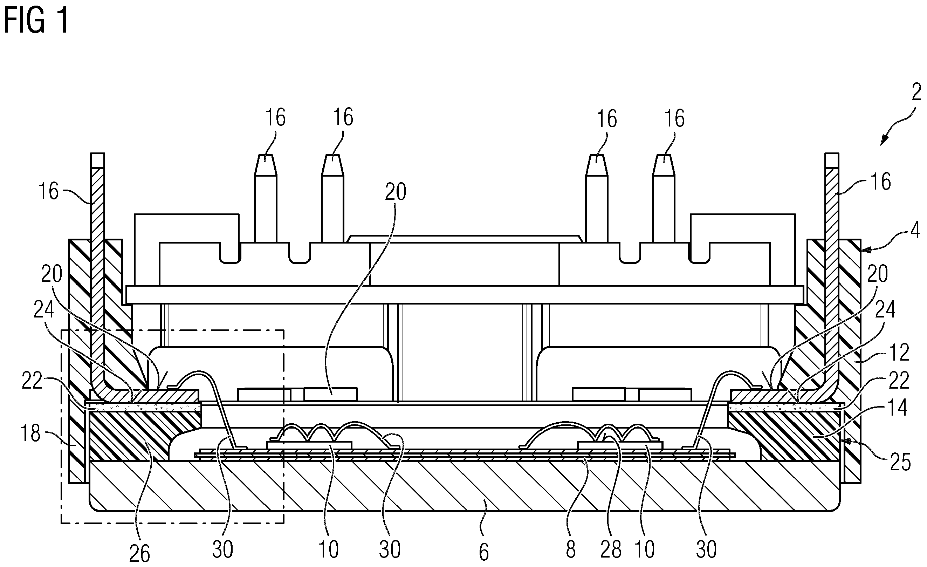

FIG 1 zeigt eine schematische Schnittdarstellung einer ersten Ausführungsform einer Anordnung 2 mit einem Gehäuseteil 4 und einer Bodenplatte 6. Ein Substrat 8, auf welchem Halbleiterelemente 10 stoffschlüssig verbunden sind, ist auf einer den Halbleiterelementen 10 abgewandten Seite mit der metallischen Bodenplatte 6 verbunden. Das Substrat 8 umfasst eine beidseitig metallisierte dielektrische Materiallage, die einen keramischen Werkstoff, beispielsweise Aluminiumnitrid oder Aluminiumoxid, oder einen organischen Werkstoff, beispielsweise einem Polyamid enthält. Die dielektrische Materiallage kann eine Dicke von 25 µm bis 600 µm, insbesondere 50 µm bis 320 µm, aufweisen. Die Halbleiterelemente 10 können unter anderem als, insbesondere vertikale, Transistoren und/oder als Dioden ausgeführt sein. Ein Transistor kann unter anderem als Insulated-Gate-Bipolar-Transistor (IGBT), als Metalloxide-Semiconductor-Field-Effect-Transistor (MOSFET) oder als Bipolartransistor ausgeführt sein. Ferner kann zumindest einem Transistor eine, insbesondere antiparalell geschaltete, Diode zugewiesen sein. Die stoffschlüssige Verbindung der Halbleiterelemente 10 mit dem Substrat 8 ist unter anderem durch Löten und/oder Sintern herstellbar.

Der Gehäuseteil 4 weist eine erste Gehäusekomponente 12 und eine zweite Gehäusekomponente 14 auf, wobei die erste Gehäusekomponente 12 eine Mehrzahl von Pins 16 aufweist, welche zur elektrischen Verbindung mit dem Substrat 8 konfiguriert sind. Die Pins 16 sind jeweils zum Teil in einen ersten Kunststoffrahmen 18 eingegossen und stehen über den Kunststoffrahmen 18 hinaus. Ein Kontaktierungsbereich 17 der Pins 16 ist zur Herstellung einer Verbindung, z.B. Lötverbindung oder Pressfit-Verbindung, mit einer Leiterplatte, konfiguriert. Ferner umfassen die Pins 16 jeweils eine Verdrahtungsfläche 20, welche unter anderem als eine Bondfläche ausgeführt sein kann, ausgebildet ist, welche zur Herstellung einer elektrischen Verbindung zwischen dem Pin 16 und zumindest einem der Halbleiterelemente 10 konfiguriert ist. Der erste Kunststoffrahmen 18 in FIG 1 ist ringförmig, insbesondere rechteckringförmig, ausgeführt und umgibt das Substrat 8 vollständig. In der ersten Gehäusekomponente 12 ist die zweite Gehäusekomponente 14 zur Ausbildung des Gehäuseteils 4 eingelegt, wobei die zweite Gehäusekomponente 14 kraftschlüssig mit der ersten Gehäusekomponente 12 verbunden wird. Beispielsweise wird die zweite Gehäusekomponente 14 über eine Außenfläche 25 mit der ersten Gehäusekomponente 12 verklemmt. Die zweite Gehäusekomponente 14 umfasst einen schwingungsdämpfenden Werkstoff 22, der beispielsweise Silikon enthalten kann. Der schwingungsdämpfende Werkstoff 22 ist auf einer Kontaktfläche 24, welche auf einer der Verdrahtungsfläche 20 abgewandten Seite der ersten Gehäusekomponente 12 angeordnet ist, lose kontaktiert. Unter einer losen Kontaktierung ist zu verstehen, dass der schwingungsdämpfende Werkstoff 22 lösbar, das heißt z.B. ohne eine stoffschlüssige Verbindung wie eine adhäsive Verbindung, mit der Kontaktfläche 24 kontaktiert ist. Die lose Kontaktierung kann ein Anpressen des schwingungsdämpfende Werkstoffs 22 einschließen.

Die zweite Gehäusekomponente 14 in FIG 1 umfasst einen zweiten Kunststoffrahmen 26, der in FIG 1 ist ringförmig, insbesondere rechteckringförmig, ausgeführt ist. Auf den zweiten Kunststoffrahmen 26 wird vor dem Einlegen in die erste Gehäusekomponente 12 umlaufend der schwingungsdämpfende Werkstoff 22 aufgebracht. Beispielsweise kann das Silikon des schwingungsdämpfenden Werkstoffs 22 im ausgehärteten Zustand lösbar mit der Kontaktfläche 24 verbunden werden, sodass der schwingungsdämpfende Werkstoff 22 lose auf der Kontaktfläche 24 aufliegt oder durch loses Anpressen kontaktiert ist. Beispielhaft ist der zweiten Kunststoffrahmen 26 der zweiten Gehäusekomponente 14 durch Verklemmen kraftschlüssig mit dem ersten Kunststoffrahmen 18 der ersten Gehäusekomponente 12 verbunden. Ferner ist der Gehäuseteil 4 derartig mit der Bodenplatte 6 verbunden, dass der zweite Kunststoffrahmen 26 der zweiten Gehäusekomponente 14 mit der Bodenplatte 6 in unmittelbarem Kontakt steht. Beispielsweise ist der Gehäuseteil 4 adhäsiv mit der Bodenplatte 6 verbunden.

Die Halbleiterelemente 10 weisen auf einer dem Substrat 8 abgewandten Seite Halbleiter-Verdrahtungsflächen 28 auf. Zur elektrischen Verbindung der Pins 16 mit den Halbleiterelementen 10 sind Verdrahtungselemente 30 vorgesehen. Die Verdrahtungselemente 30 können unter anderem als Bonddrähte oder Bondbänder ausgeführt sein. In FIG 1 sind Verdrahtungsflächen 20 der Pins 16 über Verdrahtungselemente 30 mit dem Substrat 8 verbunden, wobei das Substrat 8 über Verdrahtungselemente 30 mit den Halbleiter-Verdrahtungsflächen 28 verbunden ist. Alternativ kann zumindest eine Verdrahtungsfläche 20 eines Pins 16 über zumindest ein Verdrahtungselemente 30 direkt mit einer Halbleiter-Verdrahtungsflächen 28 verbunden sein. Die Verdrahtungselemente 30 werden beispielsweise in einem Ultraschall-Drahtbond-Verfahren verschweißt. Bei der Herstellung der Bondverbindung auftretende Schwingungen werden zumindest teilweise durch den schwingungsdämpfende Werkstoff 22 gedämpft.

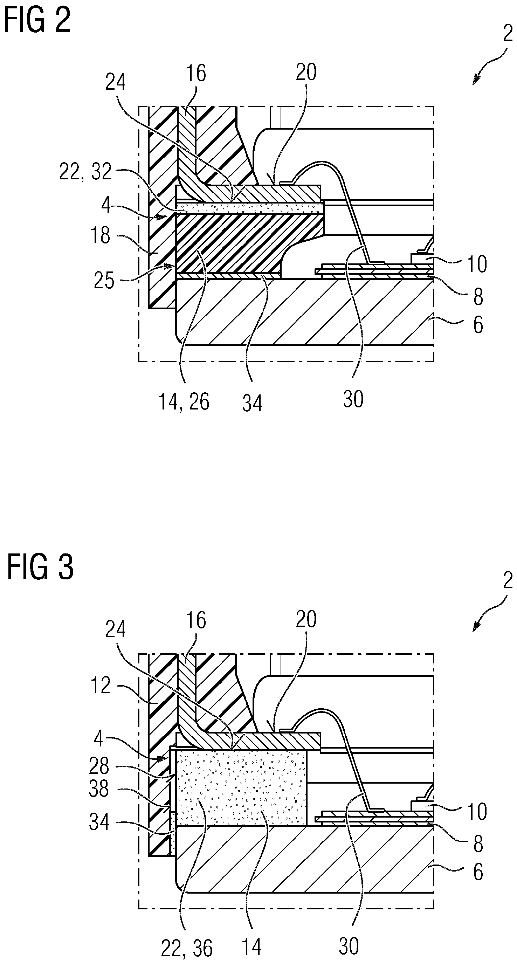

FIG 2 zeigt eine vergrößerte schematische Schnittdarstellung der ersten Ausführungsform der Anordnung 2. Der schwingungsdämpfende Werkstoff 22 ist als eine umlaufend auf dem ringförmigen, insbesondere rechteckringförmigen, zweiten Kunststoffrahmen 26 angeordnete Silikonschicht 32 ausgeführt. Die Silikonschicht 32 ist durch ein Siebdruckverfahren, Schablonendruckverfahren oder durch Dispensen auf den zweiten Kunststoffrahmen 26 aufgebracht bzw. appliziert. Vor dem Einlegen der zweiten Gehäusekomponente 14 wird das Silikon ausgehärtet. Durch ein derartiges Vorapplizieren ist die ausgehärtete Silikonschicht 32 lose bzw. lösbar mit der Kontaktfläche 24 kontaktierbar. Die Silikonschicht 32 kann eine Dicke im Bereich von 50 µm bis 1 mm aufweisen. Der als Silikonschicht 32 ausgeführte schwingungsdämpfende Werkstoff 22 wird auf der Kontaktfläche 24 im Wesentlichen vollflächig kontaktiert, sodass eine optimale Schwingungsdämpfung erzielbar ist. Der Gehäuseteil 4 wird durch eine adhäsive Verbindung 34 des zweiten Kunststoffrahmens 26 mit der Bodenplatte 6 stoffschlüssig verbunden. Die adhäsive Verbindung 34 wird beispielsweise mittels eines Klebstoffs hergestellt, der unter Spannung, welche durch Verpressen des Gehäuseteils 4 mit der Bodenplatte hergestellt wird, ausgehärtet wird. Die weitere Ausführung des Anordnung 2 in FIG 2 entspricht der Ausführung in FIG 1.

FIG 3 zeigt eine vergrößerte schematische Schnittdarstellung einer zweiten Ausführungsform einer Anordnung 2 mit einem Gehäuseteil 4 und einer Bodenplatte 6, wobei die zweiten Gehäusekomponente 14 des Gehäuseteils 4 als schwingungsdämpfender Rahmen 36 aus dem schwingungsdämpfenden Werkstoff 22 ausgeführt ist. Beispielsweise ist der schwingungsdämpfende Rahmen 36 als ringförmiger, insbesondere rechteckringförmiger Silikonrahmen oder Gummirahmen ausgeführt, der eine im Wesentlichen über den Umfang konstante rechteckige oder quadratische Querschnittsfläche aufweist. Der Gehäuseteil 4 wird dadurch stoffschlüssig mit der Bodenplatte 6 verbunden, dass eine adhäsive Verbindung 34 des ersten Kunststoffrahmens 18 mit der Bodenplatte 6 hergestellt wird. Die adhäsive Verbindung 34 wird über eine Innenfläche 38 des ersten Kunststoffrahmens 18 zur Bodenplatte 6 hergestellt, wobei sich ein Klebstoff der adhäsiven Verbindung 34 über zumindest einen Teil einer Außenfläche 25 des schwingungsdämpfenden Rahmens 36 erstrecken kann. Durch Verpressen des Gehäuseteils 4 mit der Bodenplatte wird der Klebstoff unter Spannung ausgehärtet. Die weitere Ausführung des Anordnung 2 in FIG 3 entspricht der Ausführung in FIG 2.

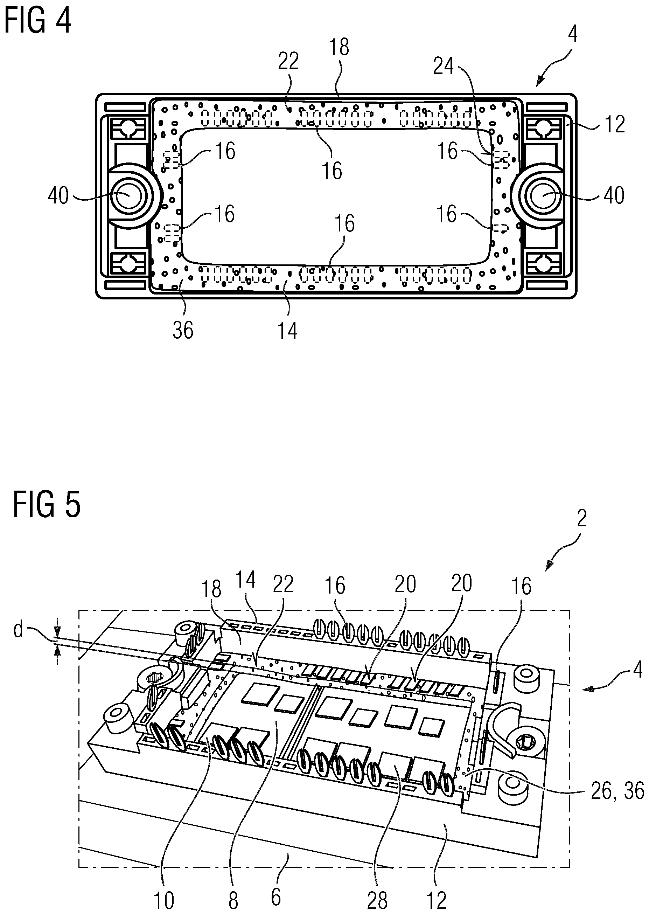

FIG 4 zeigt eine schematische Darstellung eines Gehäuseteils 4 in einer Draufsicht, wobei die erste Gehäusekomponente 12 einen rechteckringförmigen ersten Kunststoffrahmen 18 umfasst, in welchem Pins 16 jeweils zum Teil eingegossen sind. Die zweite Gehäusekomponente 14 des Gehäuseteils 4 ist als schwingungsdämpfender Rahmen 36 aus dem schwingungsdämpfenden Werkstoff 22 ausgeführt. Beispielhaft ist der schwingungsdämpfende Rahmen 36 als ringförmiger, insbesondere rechteckringförmiger Silikonrahmen ausgeführt, der bündig mit den Kontaktflächen 24 der Pins 16 abschließen oder zumindest teilweise über die Kontaktflächen 24 der Pins 16 überstehen kann. Der Silikonrahmen liegt lose auf den Kontaktflächen 24 der Pins 16 auf. Alternativ kann der Silikonrahmen im ausgehärteten Zustand zumindest teilweise über eine adhäsive Verbindung mit den Kontaktflächen 24 der Pins 16 verbunden sein. Ausnehmungen 40, welche beispielsweise als Gewindebohrungen ausgeführt sind, können konfiguriert sein, den Gehäuseteil 4 über eine formschlüssige Verbindung, insbesondere Schraubverbindung, auf einer Bodenplatte, welche aus Gründen der Übersichtlichkeit in FIG 4 nicht dargestellt ist, anzupressen. Die Verbindung des Gehäuseteils 4 mit der Bodenplatte erfolgt in einem weiteren Schritt. Die weitere Ausführung des Gehäuseteils 4 in FIG 4 entspricht der Ausführung in FIG 3.

FIG 5 zeigt eine dreidimensionale Darstellung einer dritten Ausführungsform einer Anordnung 2 mit einem Gehäuseteil 4 und einer Bodenplatte 6. Der schwingungsdämpfende Rahmen 36 ist als ringförmiger, insbesondere rechteckringförmiger Silikonrahmen ausgeführt, der teilweise über die Kontaktflächen 24 der Pins 16 übersteht, jedoch vom Substrat 8 einen im Wesentlichen umlaufenden Abstand d aufweist und auf der Bodenplatte 6 flächig aufliegt. Eine Verdrahtung der Pins 16 und der Halbleiterelemente 10 ist in FIG 5 noch nicht erfolgt und findet in einem weiteren Schritt statt. Die weitere Ausführung der Anordnung 2 in FIG 4 entspricht der Ausführung in FIG 3.

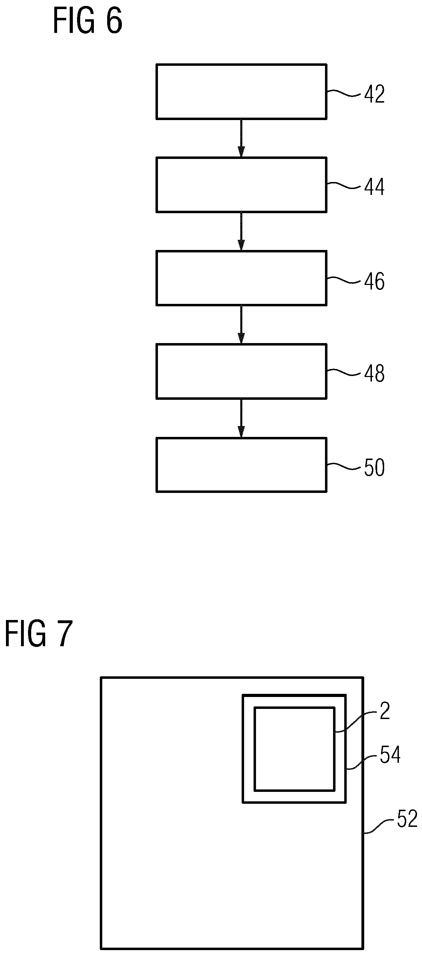

FIG 6 zeigt ein Ablaufdiagramm eines Verfahrens zur Herstellung eines Halbleitermoduls, welches ein Gehäuse mit einem Gehäuseteil zur Aufnahme eines Halbleiterelements, zumindest ein Halbleiterelement und eine Bodenplatte umfasst, wobei die Herstellung ein Ausbilden 42 einer ersten Gehäusekomponente des Gehäuseteils umfasst, wobei wenigstens ein Pin, welcher zur elektrischen Verbindung mit einem Substrat konfiguriert ist, zumindest teilweise in einen ersten Kunststoffrahmen eingegossen wird, wobei an dem Pin eine Verdrahtungsfläche ausgebildet wird, welche zur Herstellung einer elektrischen Verbindung zwischen dem Pin und dem Halbleiterelement konfiguriert ist.

In einem darauffolgenden Schritt erfolgt ein Einlegen 44 einer zweiten Gehäusekomponente welche einen schwingungsdämpfenden Werkstoff aufweist, in die erste Gehäusekomponente zur Ausbildung des Gehäuseteils des Gehäuses, wobei der schwingungsdämpfende Werkstoff auf einer Kontaktfläche, welche auf einer der Verdrahtungsfläche abgewandten Seite der ersten Gehäusekomponente angeordnet ist, lose kontaktiert wird.

In einem darauffolgenden Schritt erfolgt ein Verbinden 46 des Gehäuseteils mit der Bodenplatte, wobei auf der Bodenplatte ein Substrat stoffschlüssig verbunden ist. Auf dem Substrat ist das zumindest eine Halbleiterelemente stoffschlüssig verbunden. Die zweite Gehäusekomponente wird hierbei mit der Bodenplatte unmittelbar kontaktiert. Unter einer unmittelbaren Kontaktierung ist eine direkte Kontaktierung zu verstehen, die Verbindungsmittel zur Herstellung einer stoffschlüssigen Verbindung wie Kleber einschließt, zusätzliche Verbindungselemente wie Abstandshalter jedoch ausschließt.

In einem weiteren Schritt erfolgt ein Verdrahten 48 der Pins mit dem zumindest einen Halbleiterelement, wobei beispielhaft Pins über Verdrahtungselemente mit dem Substrat verbunden werden, wobei das Substrat über Verdrahtungselemente mit dem zumindest einen Halbleiterelement verbunden wird. Alternativ kann zumindest ein Pin über zumindest ein Verdrahtungselement direkt mit dem zumindest einen Halbleiterelement verbunden werden. Die Verdrahtungselemente werden beispielsweise in einem Ultraschall-Drahtbond-Verfahren verschweißt. Beim Verdrahten 48 auftretende Schwingungen werden zumindest teilweise durch den schwingungsdämpfenden Werkstoff gedämpft.

In einem weiteren Schritt erfolgt ein Vergießen und Verschließen 50 des Halbleitermoduls. Durch eine Vergussmasse, welche z.B. Silikon enthält, werden erforderliche Spannungsabstände eingehalten. Ferner dient ein derartiger Verguss zum Schutz vor schädlichen Umwelteinflüssen. Das Gehäuse wird durch einen Gehäusedeckel verschlossen, wobei der Gehäusedeckel mit dem Gehäuseteil verbunden wird.

FIG 7 zeigt eine schematische Darstellung eines Stromrichters 52, welcher ein Halbleitermodul 54, das eine Anordnung 2 aufweist, umfasst. Der Stromrichter 52 kann mehr als ein Halbleitermodul 54 umfassen. Zumindest ein Halbleitermodul 54 kann mehr als eine Anordnung 2 umfassen.

Zusammenfassend betrifft die Erfindung ein Verfahren zur Herstellung einer Anordnung 2 mit einem Gehäuseteil 4 zur Aufnahme eines Halbleiterelements 10 und einer Bodenplatte 6. Um ein möglichst einfaches und kostengünstiges Herstellungsverfahren anzugeben, welche eine zuverlässige Verdrahtung ermöglicht, werden folgende Schritte vorgeschlagen: Ausbilden 42 einer ersten Gehäusekomponente 12, wobei zumindest ein Pin 16 zumindest teilweise in einen ersten Kunststoffrahmen 18 eingegossen wird, wobei an dem Pin 16 eine Verdrahtungsfläche 20 ausgebildet ist, Einlegen 44 einer zweiten Gehäusekomponente 14, welche einen schwingungsdämpfenden Werkstoff 22 aufweist, in die erste Gehäusekomponente 12 zur Ausbildung des Gehäuseteils 4, wobei der schwingungsdämpfende Werkstoff 22 auf einer Kontaktfläche 24, welche auf einer der Verdrahtungsfläche 20 abgewandten Seite der ersten Gehäusekomponente 12 angeordnet ist, lose kontaktiert wird, Verbinden 46 des Gehäuseteils 4 mit der Bodenplatte 6, wobei die zweite Gehäusekomponente 14, insbesondere unmittelbar, mit der Bodenplatte 6 kontaktiert wird.

## Patentansprüche

1. Verfahren zur Herstellung einer Anordnung (2) mit einem Gehäuseteil (4) zur Aufnahme eines Halbleiterelements (10) und einer Bodenplatte (6) umfassend folgende Schritte:
- Ausbilden (42) einer ersten Gehäusekomponente (12),
wobei zumindest ein Pin (16) zumindest teilweise in einen ersten Kunststoffrahmen (18) eingegossen wird,
wobei an dem Pin (16) eine Verdrahtungsfläche (20) ausgebildet ist,
- Einlegen (44) einer zweiten Gehäusekomponente (14), welche einen schwingungsdämpfenden Werkstoff (22) aufweist, in die erste Gehäusekomponente (12) zur Ausbildung des Gehäuseteils (4),
wobei der schwingungsdämpfende Werkstoff (22) auf einer Kontaktfläche (24), welche auf einer der Verdrahtungsfläche (20) abgewandten Seite der ersten Gehäusekomponente (12) angeordnet ist, lose kontaktiert wird,
- Verbinden (46) des Gehäuseteils (4) mit der Bodenplatte (6),
wobei die zweite Gehäusekomponente (14), insbesondere unmittelbar, mit der Bodenplatte (6) kontaktiert wird.

2. Verfahren nach Anspruch 1,
wobei der schwingungsdämpfende Werkstoff (22) auf der Kontaktfläche (24) flächig, insbesondere vollflächig, kontaktiert wird.

3. Verfahren nach einem der Ansprüche 1 oder 2,
wobei auf der Bodenplatte (6) zumindest ein Halbleiterelement (10) angeordnet wird,
wobei nach dem Verbinden (46) des Gehäuseteils (4) mit der Bodenplatte (6) ein Verdrahten (48) der Verdrahtungsfläche (20) des Pins (16) mit dem Halbleiterelement (10) erfolgt,
wobei beim Verdrahten (48) der Verdrahtungsfläche (20) auftretende Schwingungen zumindest teilweise durch den schwingungsdämpfenden Werkstoff (22) gedämpft werden.

4. Verfahren nach Anspruch 3,
wobei das zumindest eine Halbleiterelement (10) vor dem Verbinden (46) des Gehäuseteils (4) mit der Bodenplatte (6) über ein Substrat (8) elektrisch isolierend und thermisch leitend mit der Bodenplatte (6) verbunden wird.

5. Verfahren nach einem der vorherigen Ansprüche,
wobei das Verbinden (46) des Gehäuseteils (4) durch eine stoffschlüssige, insbesondere adhäsive, Verbindung der ersten Gehäusekomponente (12) und/oder der der zweiten Gehäusekomponente (14) mit der Bodenplatte (6) erfolgt.

6. Verfahren nach einem der vorherigen Ansprüche,
wobei die zweiten Gehäusekomponente (14) einen zweiten Kunststoffrahmen (26) umfasst, auf welchem vor dem Einlegen (44), insbesondere umlaufend, der schwingungsdämpfende Werkstoff (22) aufgebracht wird.

7. Verfahren nach einem der vorherigen Ansprüche,
wobei beim Einlegen (44) der zweiten Gehäusekomponente (14) eine kraftschlüssige Verbindung zwischen den Gehäusekomponenten (12, 14) hergestellt wird.

8. Verfahren nach einem der vorherigen Ansprüche,
wobei der schwingungsdämpfende Werkstoff (22) als, insbesondere umlaufende, Silikonschicht (32) ausgeführt ist,
welche durch ein Siebdruckverfahren oder durch Dispensen auf den zweiten Kunststoffrahmen (26) aufgebracht und anschließend ausgehärtet wird,
wobei die ausgehärtete Silikonschicht (32) beim Einlegen der zweiten Gehäusekomponente (14), insbesondere flächig, mit der Kontaktfläche (24) kontaktiert wird,

9. Verfahren nach einem der Ansprüche 1 bis 5,
wobei die zweiten Gehäusekomponente (14) als schwingungsdämpfender Rahmen (36), welcher aus dem schwingungsdämpfenden Werkstoff (22) hergestellt ist, ausgeführt ist.

10. Verfahren nach Anspruch 9,
wobei beim Einlegen (44) der zweiten Gehäusekomponente (14) eine kraftschlüssige Verbindung zwischen der ersten Gehäusekomponente (12) und dem schwingungsdämpfenden Rahmen (36) hergestellt wird.

11. Anordnung (2) mit einem Gehäuseteil (4) zur Aufnahme eines Halbleiterelements (10) und einer Bodenplatte (6),
wobei der Gehäuseteil (4) eine erste Gehäusekomponente (12) und eine zweite Gehäusekomponente (14) umfasst,
wobei die erste Gehäusekomponente (12) wenigstens einen Pin (16) aufweist,
wobei der Pin (16) zumindest teilweise in einen ersten Kunststoffrahmen (18) eingegossen ist,
wobei an dem Pin (16) eine Verdrahtungsfläche (20) ausgebildet ist,
wobei die zweite Gehäusekomponente (14) in der ersten Gehäusekomponente (12) zur Ausbildung des Gehäuseteils (4) eingelegt ist,
wobei die zweite Gehäusekomponente (14) einen schwingungsdämpfenden Werkstoff (22) aufweist,
wobei der schwingungsdämpfende Werkstoff (22) auf einer Kontaktfläche (24), welcher auf einer der Verdrahtungsfläche (20) abgewandten Seite der ersten Gehäusekomponente (12) angeordnet ist, lose kontaktiert ist,
wobei der Gehäuseteil (4) derartig mit der Bodenplatte (6) verbunden ist, dass die zweite Gehäusekomponente (14) mit der Bodenplatte (6) in, insbesondere unmittelbarem, Kontakt steht.

12. Anordnung (2) nach Anspruch 11,
wobei der schwingungsdämpfende Werkstoff (22) auf der Kontaktfläche (24) flächig, insbesondere vollflächig, kontaktiert ist.

13. Halbleitermodul (54) mit mindestens einer Anordnung (2) nach einem der Ansprüche 11 oder 12.

14. Stromrichter (52) mit mindestens einem Halbleitermodul (54) nach Anspruch 13.

15. Computerprogrammprodukt, umfassend Befehle, die bei einer Ausführung des Programms durch einen Computer diesen veranlassen, ein, insbesondere mechanisches und/oder elektrisches, Verhalten der Anordnung (2) nach einem der Ansprüche 11 oder 12 zu simulieren.
